# DEMANDE DE BREVET EUROPEEN

(11) **EP 4 521 133 A1**
(43) Date de publication de la demande: **12.03.2025**
(21) Numéro de dépôt: 24198671.0
(22) Date de dépôt: 05.09.2024
(51) Int. Cl.: G01R 31/69, G01R 31/11

(54) **INSTALLATION DE RÉFLECTOMÉTRIE POUR LA DÉTECTION DE DÉFAUTS SUR UN CONNECTEUR D'UN RÉSEAU ÉLECTRIQUE**

(30) Priorité: 08.09.2023 FR 2309475
(71) Demandeur: NAVAL Group, 75015 Paris (FR)
(72) Inventeur: TOQUET, Nicolas, 50104 CHERBOURG-OCTEVILLE CEDEX (FR); KERAUDREN, Philippe, 50104 CHERBOURG-OCTEVILLE CEDEX (FR)
(74) Mandataire: Lavoix

(57) **Abrégé**

L'invention concerne une installation (10) de réflectométrie pour la détection de défauts sur un connecteur d'un réseau électrique, comprenant une pluralité d'éléments (32) de connexion. L'installation comprend :
- un réflectomètre (14) apte à envoyer un signal de sonde vers l'un desdits éléments ;
- un commutateur (16), comprenant une entrée (24), apte à être connectée au réflectomètre et une pluralité de sorties (26, 27, 28) ; et
- un dispositif (18) de liaison, apte à relier électriquement chacun des éléments (32) de connexion du connecteur à une sortie (26, 27, 28) distincte du commutateur.

Le commutateur (16) est configuré pour connecter l'entrée (24), successivement à chacune des sorties (26, 27, 28), en reliant simultanément à la masse les autres sorties.

## Description

La présente invention concerne une installation de réflectométrie pour la détection de défauts sur un connecteur d'un réseau électrique, ledit connecteur comprenant une pluralité de premiers éléments de connexion, l'installation de réflectométrie comprenant un réflectomètre apte à envoyer un signal de sonde vers l'un desdits premiers éléments de connexion.

En particulier, l'invention se rapporte à une installation de réflectométrie adaptée pour détecter des défauts sur un connecteur multipoints durci d'un réseau électrique.

De telles installations se rencontrent par exemple dans des systèmes de sous-marins, de fusées ou encore de véhicules spatiaux et permettent de détecter des défauts électriques au sein de systèmes complexes et/ou conçus pour des environnements sévères. Une installation du type précité est notamment décrite dans le document FR3066825 au nom de la Demanderesse.

Cependant, une telle installation implique de tester chaque point de connexion d'un connecteur à l'aide d'un dispositif de réflectométrie configuré pour ledit point de connexion. De multiples opérations de montage et démontage sont donc nécessaires pour tester tous les points de connexion d'un connecteur. Ces opérations sont chronophages et leur répétition peuvent conduire à une dégradation du connecteur.

La présente invention a pour but de proposer une installation de réflectométrie permettant de tester chaque point de connexion d'un connecteur à l'aide d'un même appareillage, simplifiant ainsi les opérations de montage et démontage avec ledit connecteur.

A cet effet, l'invention a pour objet une installation de réflectométrie du type précité, comprenant en outre : un commutateur, ledit commutateur comprenant : une entrée, apte à être connectée au réflectomètre ; et une pluralité de sorties ; et un dispositif de liaison, apte à être assemblé avec d'une part le connecteur et d'autre part le commutateur, de sorte à relier électriquement chacun des premiers éléments de connexion du connecteur à une sortie distincte du commutateur. Le commutateur est configuré pour connecter l'entrée, successivement à chacune des sorties, en reliant simultanément à la masse les autres sorties.

Suivant d'autres aspects avantageux de l'invention, l'installation de réflectométrie comporte l'une ou plusieurs des caractéristiques suivantes, prises isolément ou suivant toutes les combinaisons techniquement possibles :
- le commutateur comprend un nombre entier n, supérieur ou égal à 4, de sorties, le commutateur comprenant en outre : une unité primaire ; et un nombre entier m, supérieur ou égal à 2, d'unités secondaires ; l'unité primaire comprenant : une entrée primaire, reliée à l'entrée du commutateur ; et un nombre m de sorties primaires ; chaque unité secondaire comprenant : une entrée secondaire, reliée à une sortie primaire distincte de l'unité primaire ; et une pluralité de sorties secondaires, un nombre total de sorties secondaires étant égal à n, chaque sortie secondaire étant reliée à l'une des sorties du commutateur ;
- chaque unité secondaire comprend un même nombre i de sorties secondaires, i étant un entier supérieur ou égal à 2 et tel que m*i = n ;
- le dispositif de liaison comporte une pluralité de deuxièmes éléments de connexion et une pluralité de troisièmes éléments de connexion, chaque deuxième élément de connexion étant relié électriquement à un troisième élément de connexion distinct ; le dispositif de liaison étant apte à être assemblé au connecteur de sorte que chaque premier élément de connexion dudit connecteur soit en contact électrique avec l'un des deuxièmes éléments de connexion, le dispositif de liaison étant apte à être assemblé au commutateur de sorte que chaque troisième élément de connexion soit en contact électrique avec une sortie distincte dudit commutateur ;
- l'installation de réflectométrie comprend en outre un module électronique de commande, relié au commutateur et apte à commander une connexion de l'entrée du commutateur, successivement à chacune des sorties dudit commutateur, en reliant simultanément à la masse les autres sorties dudit commutateur.

L'invention se rapporte en outre à un procédé de mise en oeuvre d'une installation de réflectométrie telle que décrite ci-dessus, le procédé comprenant les étapes suivantes :
- assemblage du dispositif de liaison avec d'une part le connecteur et d'autre part le commutateur, de sorte à relier électriquement chacun des premiers éléments de connexion du connecteur à une sortie distincte du commutateur ;
- connexion du réflectomètre avec l'entrée du commutateur ;
   puis
- connexion de l'entrée du commutateur avec une première sortie dudit commutateur, les autres sorties dudit commutateur étant simultanément reliées à la masse ;
- envoi par le réflectomètre d'un premier signal de sonde vers l'entrée du commutateur ;
- réception d'un éventuel premier signal réfléchi, émis par le connecteur vers le réflectomètre.

Suivant d'autres aspects avantageux de l'invention, le procédé comporte l'une ou plusieurs des caractéristiques suivantes, prises isolément ou suivant toutes les combinaisons techniquement possibles :
- le procédé comprend ensuite les étapes suivantes : connexion de l'entrée du commutateur avec une deuxième sortie dudit commutateur, les autres sorties dudit commutateur étant simultanément reliées à la masse ; envoi par le réflectomètre d'un deuxième signal de sonde vers l'entrée du commutateur ; réception d'un éventuel deuxième signal réfléchi, émis par le connecteur vers le réflectomètre ;
- le premier signal de sonde est un signal hyperfréquence.

L'invention sera mieux comprise à la lecture de la description qui va suivre, donnée uniquement à titre d'exemple non limitatif et faite en se référant aux dessins sur lesquels :
[Fig 1] la figure 1 est une vue schématique d'une installation de réflectométrie selon un mode de réalisation de l'invention, comprenant un commutateur ; et
[Fig 2] la figure 2 est une vue schématique d'un commutateur pour l'installation de la figure 1, selon un mode de réalisation de l'invention.

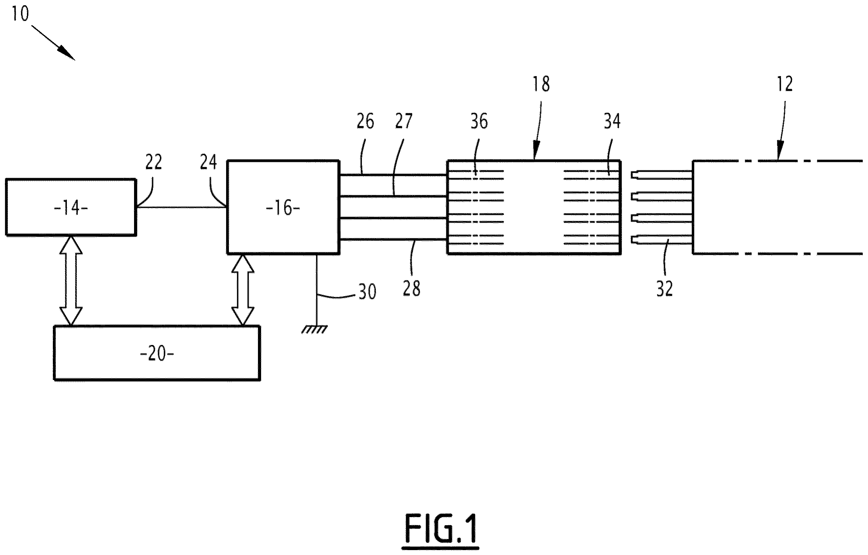

La figure 1 est une représentation schématique d'une installation 10 de réflectométrie selon un mode de réalisation de l'invention. L'installation 10 est notamment destinée à détecter des défauts sur un connecteur 12 d'un réseau électrique.

L'installation 10 comporte un réflectomètre 14, un commutateur 16 et un dispositif 18 de liaison. Dans le mode de réalisation représenté, l'installation 10 comporte en outre un module électronique 20 de commande.

Le réflectomètre 14 comporte un port 22 de connexion. Le réflectomètre 14 est apte à envoyer un signal de sonde, via ledit port 22 de connexion, et à recevoir un éventuel signal réfléchi. Préférentiellement, le réflectomètre 14 est apte à envoyer un signal de fréquence élevée, plus préférentiellement un signal hyperfréquence.

Le commutateur 16 comprend : une entrée 24 ; une pluralité de sorties 26, 27, 28 ; et une liaison 30 à la terre ou à la masse.

L'entrée 24 est apte à être connectée au port 22 de connexion du réflectomètre 14.

Dans la suite de la description, on considère que le commutateur 16 comprend un nombre n de sorties, n étant un entier positif, de préférence supérieur ou égal à 4. Plus préférentiellement, le nombre n de sorties du commutateur 16 est compris entre 12 et 64.

Dans le cas d'une installation 10 disposée dans un équipement terrestre, la liaison 30 relie le commutateur 16 à la terre. Dans le cas d'une installation 10 disposée dans un équipement non terrestre, par exemple un équipement aquatique ou aérien, la liaison 30 relie le commutateur 16 à la masse, par exemple à la masse du réflectomètre 14, ou à un blindage ou à une structure dudit équipement non terrestre.

Comme il sera plus précisément décrit ci-après, le commutateur 16 est configuré pour connecter l'entrée 24, successivement à chacune des sorties 26, 27, 28, en connectant simultanément les autres sorties à la liaison 30 à la terre ou à la masse.

Le dispositif 18 de liaison est apte à être assemblé avec d'une part le connecteur 12 et d'autre part le commutateur 16, de sorte à relier électriquement ledit connecteur et ledit commutateur.

Plus précisément, dans le mode de réalisation représenté, le connecteur 12 comprend une pluralité de premiers éléments 32 de connexion, sensiblement identiques. Les premiers éléments 32 de connexion sont par exemple matérialisés par des tiges métalliques.

Dans la suite de la description, on considère que le connecteur 12 comprend un nombre k de premiers éléments 32 de connexion.

Le dispositif 18 de liaison est configuré de sorte à relier électriquement chacun des premiers éléments 32 de connexion du connecteur 12 à une sortie 26, 27, 28 distincte du commutateur 16.

Dans le mode de réalisation représenté, le dispositif 18 de liaison comporte une pluralité de deuxièmes éléments 34 de connexion et une pluralité de troisièmes éléments 36 de connexion. Chaque deuxième élément 34 de connexion est relié électriquement à un troisième élément 36 de connexion distinct.

Le dispositif 18 de liaison et le connecteur 12 sont configurés pour s'assembler de manière réversible, de sorte à mettre en contact électrique chacun des premiers éléments 32 de connexion du connecteur 12 avec un deuxième élément 34 de connexion correspondant du dispositif 18.

De même, le dispositif 18 de liaison et le commutateur 16 sont configurés pour s'assembler de manière réversible, de sorte à mettre en contact électrique chacun des troisièmes éléments 36 de connexion avec une sortie 26, 27, 28 distincte du commutateur 16.

De préférence, le dispositif 18 de liaison est spécifiquement adapté au connecteur 12. En particulier, le nombre de deuxièmes éléments 34 de connexion et le nombre de troisièmes éléments 36 de connexion sont tous deux égaux à k.

De préférence, le dispositif 18 de liaison est configuré pour assurer une continuité d'impédance entre chaque troisième élément 36 de connexion et chaque deuxième élément 34 de connexion correspondant.

Le module électronique 20 de commande est relié au commutateur 16 et apte à commander une connexion de l'entrée 24 du commutateur 16, successivement à chacune des sorties 26, 27, 28 dudit commutateur, en connectant simultanément les autres sorties dudit commutateur à la liaison 30 à la terre ou à la masse.

De préférence, le module électronique 20 est également relié au réflectomètre 14. En particulier, le module électronique 20 est apte à commander un envoi d'un signal de sonde via le port 22 de connexion, et à analyser un éventuel signal réfléchi.

Le module électronique 20 est par exemple un ordinateur.

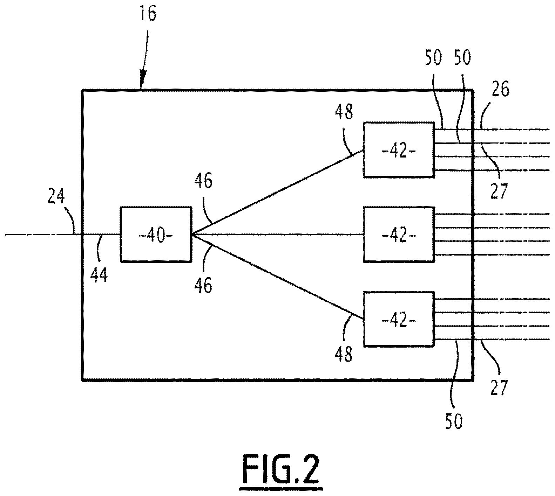

La figure 2 montre une vue de détail du commutateur 16 selon un mode particulier de réalisation de l'invention.

Selon ledit mode particulier de réalisation, le commutateur 16 comprend une unité primaire 40 et un nombre entier m, supérieur ou égal à 2, d'unités secondaires 42.

L'unité primaire 40, ou commutateur primaire, comprend une entrée primaire 44 et un nombre m de sorties primaires 46. L'entrée primaire 44 est reliée à l'entrée 24 du commutateur 16.

Chaque unité secondaire 42, ou commutateur secondaire, comprend une entrée secondaire 48 et une pluralité de sorties secondaires 50.

L'entrée secondaire 48 de chaque unité secondaire 42 est reliée à une sortie primaire 46 distincte de l'unité primaire 40. Chacune des sorties 26, 27, 28 du commutateur 16 est reliée à une sortie secondaire 50 distincte. De préférence, un nombre total de sorties secondaires 50 est égal à n et chaque sortie secondaire 50 est reliée à une sortie 26, 27, 28 distincte du commutateur 16.

Le commutateur 16 est configuré pour connecter l'entrée primaire 44 de l'unité primaire 40, successivement à chacune des sorties primaires 46 de ladite unité primaire, en connectant simultanément les autres sorties primaires 46 à la liaison 30 à la terre ou à la masse.

De même, le commutateur 16 est configuré pour connecter l'entrée secondaire 48 d'une unité secondaire 42, successivement à chacune des sorties secondaires 50 de ladite unité secondaire 42, en connectant simultanément les autres sorties secondaires 50 à la liaison 30 à la terre ou à la masse.

De préférence, chaque unité secondaire 42 comprend un même nombre i de sorties secondaires 50, i étant un entier supérieur ou égal à 2 et tel que m*i = n.

Par exemple, n = 40, m = 5 et i = 8.

De préférence, l'unité primaire 40 et les unités secondaires 42 sont disposées et configurées de sorte à assurer un chemin de propagation équivalent entre l'entrée 24 et chacune des sorties 26, 27, 28 du commutateur 16.

Dans une variante de réalisation non représentée, le commutateur comporte en outre une pluralité de commutateurs tertiaires, reliés aux sorties secondaires, afin d'ajouter un étage de répartition au commutateur

Un procédé de mise en oeuvre de l'installation 10 de réflectométrie décrite ci-dessus va maintenant être décrit.

Un tel procédé vise par exemple à détecter des défauts sur le connecteur 12 et/ou sur un système électrique raccordé audit connecteur 12. Un tel système électrique est par exemple incorporé à un équipement complexe et/ou conçu pour des conditions d'utilisation particulières, comme par exemple un équipement de sous-marin, de fusée ou de véhicule spatial.

Dans une première étape du procédé, le dispositif 18 de liaison est assemblé avec d'une part le connecteur 12 et d'autre part le commutateur 16, de sorte à relier électriquement chacun des premiers éléments 32 de connexion du connecteur à une sortie 26, 27, 28 distincte du commutateur. En parallèle, l'entrée 24 du commutateur est connectée au réflectomètre 14.

Dans une deuxième étape du procédé, l'entrée 24 du commutateur 16 est connectée à une première sortie 26 dudit commutateur, chacune des autres sorties 27, 28 dudit commutateur 16 étant connectée simultanément à la liaison 30 à la terre ou à la masse. Une telle connexion de l'entrée 24 et de la première sortie 26 du commutateur est de préférence pilotée par le module électronique 20.

Dans une troisième étape du procédé, le réflectomètre 14 envoie un signal de sonde vers l'entrée 24 du commutateur 16. Ledit signal de sonde se propage jusqu'à la première sortie 26, puis successivement jusqu'au troisième élément 36 de connexion, relié à ladite première sortie 26, du dispositif 18 de liaison.

Ledit signal de sonde se propage ensuite jusqu'au deuxième élément 34 de connexion correspondant du dispositif 18 de liaison.

L'installation 10 décrite ci-dessus est apte à assurer une continuité d'impédance entre le réflectomètre 14 et chacun des deuxièmes éléments 34 de connexion du dispositif 18 de liaison, avec une qualité suffisante pour un signal hyperfréquence. Le signal de sonde se propage donc au premier élément 32 de connexion du connecteur 12, relié au deuxième élément 34 mentionné ci-dessus.

En cas de défaut au niveau dudit premier élément 32 de connexion ou de la ligne électrique en aval, la discontinuité d'impédance associée audit défaut conduit au renvoi d'un signal réfléchi vers le réflectomètre 14. Le défaut est ainsi détecté par le module électronique 20.

Les deuxième et troisième étapes décrites ci-dessus sont répétées avec une deuxième sortie 27 du commutateur, ladite deuxième sortie 27 étant reliée à l'entrée dudit commutateur, les autres sorties 26, 28 étant simultanément reliées à la masse. Un défaut éventuel peut ainsi être détecté au niveau du premier élément 32 de connexion du connecteur 12, relié à ladite deuxième sortie 27.

Les deuxième et troisième étapes décrites ci-dessus sont ensuite répétées avec les autres sorties 28 du commutateur 16 reliées à un premier élément 32 de connexion du connecteur 12. Chacun desdits premiers éléments 32 de connexion est ainsi testé successivement.

La présence d'éventuels défauts au niveau du connecteur 12 est ainsi testée de manière non invasive, sans multiplier d'opérations de montage/démontage au niveau dudit connecteur. La qualité de la connexion du réflectomètre sur le connecteur 12 permet la reproductibilité des mesures.

## Revendications

1. Installation (10) de réflectométrie pour la détection de défauts sur un connecteur (12) d'un réseau électrique, ledit connecteur comprenant une pluralité de premiers éléments (32) de connexion ; l'installation de réflectométrie comprenant un réflectomètre (14) apte à envoyer un signal de sonde vers l'un desdits premiers éléments (32) de connexion ;
l'installation étant **caractérisée en ce qu'**elle comprend en outre :
- un commutateur (16), ledit commutateur comprenant : une entrée (24), apte à être connectée au réflectomètre ; et une pluralité de sorties (26, 27, 28) ; et
- un dispositif (18) de liaison, apte à être assemblé avec d'une part le connecteur (12) et d'autre part le commutateur (16), de sorte à relier électriquement chacun des premiers éléments (32) de connexion du connecteur à une sortie (26, 27, 28) distincte du commutateur ;
et **en ce que** le commutateur (16) est configuré pour connecter l'entrée (24), successivement à chacune des sorties (26, 27, 28), en reliant simultanément à la masse les autres sorties.

2. Installation de réflectométrie selon la revendication 1, dans laquelle le commutateur comprend un nombre entier n, supérieur ou égal à 4, de sorties (26, 27, 28), le commutateur comprenant en outre : une unité primaire (40) ; et un nombre entier m, supérieur ou égal à 2, d'unités secondaires (42) ;
l'unité primaire (40) comprenant : une entrée primaire (44), reliée à l'entrée (24) du commutateur ; et un nombre m de sorties primaires (46) ;
chaque unité secondaire (42) comprenant : une entrée secondaire (48), reliée à une sortie primaire (46) distincte de l'unité primaire ; et une pluralité de sorties secondaires (50), un nombre total de sorties secondaires étant égal à n, chaque sortie secondaire étant reliée à l'une des sorties (26, 27, 28) du commutateur.

3. Installation de réflectométrie selon la revendication 2, dans laquelle chaque unité secondaire (42) comprend un même nombre i de sorties secondaires (50), i étant un entier supérieur ou égal à 2 et tel que m*i = n.

4. Installation de réflectométrie selon l'une des revendications précédentes, dans laquelle le dispositif (18) de liaison comporte une pluralité de deuxièmes éléments (34) de connexion et une pluralité de troisièmes éléments (36) de connexion, chaque deuxième élément (34) de connexion étant relié électriquement à un troisième élément (36) de connexion distinct,
le dispositif (18) de liaison étant apte à être assemblé au connecteur (12) de sorte que chaque premier élément (32) de connexion dudit connecteur soit en contact électrique avec l'un des deuxièmes éléments (34) de connexion, le dispositif de liaison étant apte à être assemblé au commutateur (16) de sorte que chaque troisième élément (36) de connexion soit en contact électrique avec une sortie (26, 27, 28) distincte dudit commutateur.

5. Installation de réflectométrie selon l'une des revendications précédentes, comprenant en outre un module électronique (20) de commande, relié au commutateur (16) et apte à commander une connexion de l'entrée (24) du commutateur, successivement à chacune des sorties (26, 27, 28) dudit commutateur, en reliant simultanément à la masse les autres sorties dudit commutateur.

6. Procédé de mise en oeuvre d'une installation (10) de réflectométrie selon l'une des revendications précédentes, comprenant les étapes suivantes :
- assemblage du dispositif (18) de liaison avec d'une part le connecteur (12) et d'autre part le commutateur (16), de sorte à relier électriquement chacun des premiers éléments (32) de connexion du connecteur à une sortie (26, 27, 28) distincte du commutateur ;
- connexion du réflectomètre (14) avec l'entrée (24) du commutateur ;
puis
- connexion de l'entrée (24) du commutateur avec une première sortie (26) dudit commutateur, les autres sorties (27, 28) dudit commutateur étant simultanément reliées à la masse ;
- envoi par le réflectomètre (14) d'un premier signal de sonde vers l'entrée (24) du commutateur ;
- réception d'un éventuel premier signal réfléchi, émis par le connecteur (12) vers le réflectomètre.

7. Procédé selon la revendication 6, comprenant ensuite les étapes suivantes :
- connexion de l'entrée (24) du commutateur avec une deuxième sortie (27) dudit commutateur, les autres sorties (26, 28) dudit commutateur étant simultanément reliées à la masse ;
- envoi par le réflectomètre (14) d'un deuxième signal de sonde vers l'entrée (24) du commutateur ;
- réception d'un éventuel deuxième signal réfléchi, émis par le connecteur (12) vers le réflectomètre.

8. Procédé selon la revendication 6 ou la revendication 7, dans lequel le premier signal de sonde est un signal hyperfréquence.
